# EUROPÄISCHE PATENTSCHRIFT

(11) **EP 3 281 215 B1**
(45) Veröffentlichungstag und Bekanntmachung des Hinweises auf die Patenterteilung: **18.09.2019**
(21) Anmeldenummer: 16715291.7
(22) Anmeldetag: 07.04.2016
(51) Int. Cl.: H01H 85/02, G01R 15/18

(54) **STROMWANDLERSYSTEM SOWIE LASTTRENNER MIT EINEM SOLCHEN**
POWER CONVERTER SYSTEM AND LOAD INTERRUPTER COMPRISING SUCH A POWER CONVERTER SYSTEM
SYSTÈME CONVERTISSEUR DE COURANT ET SECTIONNEUR ÉQUIPÉ D'UN TEL SYSTÈME

(30) Priorität: 09.04.2015 DE 102015105441
(43) Veröffentlichungstag der Anmeldung: 14.02.2018
(73) Patentinhaber: EFEN GmbH, 65344 Eltville (DE)
(72) Erfinder: KAHLER, Klaus Dietmar, 65321 Heidenrod (DE); SCHRÖDER, Martin, 65343 Eltville (DE)
(74) Vertreter: Bienert, Frank Florian Gaël
(86) Internationale Anmeldenummer: PCT/EP2016/057594
(87) Internationale Veröffentlichungsnummer: WO 2016/162404

(56) Entgegenhaltungen:
- WO-A1-2014/090319
- DE-A1-102007 051 419
- DE-A1-102011 052 449

## Beschreibung

Die vorliegende Erfindung betrifft ein Stromwandlersystem sowie einen Lasttrenner mit einem Stromwandlersystem.

Unter Lasttrennern werden sowohl NH-Sicherungslasttrenner als auch NH-Sicherungslastschaltleisten verstanden, die im Allgemeinen ein Gehäuse mit einer Bodenfläche und mindestens einen Einspeisekontakt sowie mindestens einen Abgangskontakt aufweisen.

Solche Lasttrenner sind seit langem bekannt und dienen dazu, abgesicherte Abgänge von Sammelschienen bereitzustellen, die unter Last getrennt werden können. Dazu weisen diese Einrichtungen ein oder mehrere Sicherungsunterteile auf, die im Gehäuse angeordnet sind. Entsprechende Sicherungseinsätze sind beispielsweise an einem Schaltdeckel montiert, sodass bei geschlossenem Schaltdeckel die Sicherungseinsätze in den Sicherungsunterteilen eingesetzt sind und eine Verbindung zwischen dem jeweiligen - mit den Sammelschienen verbindbaren - Einspeisekontakten und den Abgangskontakten herstellen. Beim Öffnen des Schaltdeckels werden die Sicherungseinsätze aus den Sicherungsunterteilen gezogen, sodass die Verbindung unterbrochen ist.

Grundsätzlich kann die vorliegende Erfindung auch bei offenen Verteilerleisten eingesetzt werden, bei denen die Sicherungseinsätze mit einem geeigneten Werkzeug aus dem offenen Gehäuse gezogen werden können. Der Begriff des Lasttrenners bzw. der Begriff der NH-Sicherungsschaltleiste soll daher auch die offenen Verteilerleisten umfassen.

Für manche Anwendungszwecke ist eine Messung des Stromflusses über den bereitgestellten Abgang erwünscht. Dazu werden meist Stromwandler eingesetzt. Stromwandler arbeiten wie Transformatoren, d.h. ein durch den Abgangsanschluss (Primärleiter) fließender Wechselstrom induziert in einer vom Stromwandler bereitgestellten Sekundärleitung einen vom Primärkreis galvanisch getrennten Sekundärstrom, der zur Messung des Primärstroms ausgewertet werden kann. Somit erfolgt die Messung berührungslos.

Es sind beispielsweise Aufsteck-Stromwandler bekannt, die einen Primärleiter (beispielsweise in Form eines elektrisch leitfähigen Zylinderteils) und ein diesen umgebenden Sekundärleiter aufweisen. Bei der Montage wird der Stromwandler auf den Einspeisekontakt montiert, sodass der Primärleiter den Einspeisekontakt kontaktiert und der Primärleiter des Stromwandlers den durch den Einspeisekontakt fließenden Strom aufnimmt.

Den beschriebenen Stromwandlersystemen ist gemeinsam, dass der Anschluss des Sekundärleiters an entsprechende Auswertungseinrichtungen mühselig ist, da jeder Stromwandler mittels zweier Anschlusskabel angeschlossen werden muss und gleichzeitig eine kurzschlusssichere Verlegung zu gewährleisten ist.

Aus der DE 10 2007 051 419 ist eine NH-Sicherungslastschaltleiste bekannt, die an der Unterseite des Gehäuses ein Stromwandlermodul bestehend aus drei unterschiedlichen Stromwandlern, die jeweils mit einem Einspeisekontakt verknüpft sind, bereitstellt. Doch auch bei dieser Ausführungsform ist bei Bedarf eine entsprechende elektronische Auswertungseinrichtung mit einer Anzeigevorrichtung jeweils mit dem gewünschten Stromwandler zu verbinden. Auswertungseinrichtungen und insbesondere Anzeigevorrichtungen sind teuer und lassen sich nicht in den Schaltschränken montieren, sondern werden nur bei Bedarf mit dem entsprechenden Stromwandler verbunden.

Auch hier ist es notwendig, dass ein Techniker vor Ort den Stromwandler mit der Auswerte- und Anzeigevorrichtung verbindet, um festzustellen, wieviel Strom über den entsprechenden Abgang abgegriffen wird.

Aus der DE 10 2011 052 449 A1 ist bereits ein Stromwandlersystem bekannt, das eine Auswerteelektronik aufweist, welche die Messspannung auswertet. Dabei ist die Auswerteelektronik und der Stromwandler im Systemgehäuse des Stromwandlersystems angeordnet.

Insbesondere bei der Installation der genannten Lasttrenner in entsprechenden Schaltschränken ist häufig eine Überprüfung des Überlast- und Überspannungsverhaltens notwendig. Dabei wird u.a. der Lasttrenner mit einer höheren Spannung beaufschlagt als im Normalbetrieb vorgesehen ist, um das Verhalten des Lasttrenners zu überprüfen.

Eine Erhöhung der Spannung im Primärkreis führt jedoch automatisch zu einer Erhöhung der Spannung im Sekundärkreis, was zu einer Zerstörung der Auswerteelektronik des Stromwandlersystems führt.

Zwar ist es möglich, die Auswerteelektronik mit Hilfe einer eigenen Sicherung abzusichern, um die Zerstörung der Auswerteelektronik bei Überspannung zu verhindern, dies hat jedoch zur Folge, dass diese Sicherung nach jeder Überspannungsprüfung ausgewechselt werden muss, was entsprechend aufwändig ist.

Daher wird gegenwärtig vor der entsprechenden Überspannungsprüfung das gesamte Stromwandlersystem vom Lasttrenner getrennt und der Lasttrenner während der Überspannungsprüfung ohne Stromwandlersystem betrieben. Bei bestandener Überspannungsprüfung wird dann das Stromwandlersystem wieder an dem Lasttrenner montiert. Häufig weist der Lasttrenner jedoch drei Einspeisekontakte und drei Abgangskontakte auf, sodass auch das Stromwandlersystem drei Stromwandler aufweist, durch die jeweils der entsprechende Abgangskontakt geführt werden muss. Zusätzlich muss an den Abgangskontakt dann ein entsprechendes Stromkabel montiert werden. Um das Stromwandlersystem vom Lasttrenner zu entfernen, ist dieser spannungsfrei zu schalten und die entsprechenden Stromkabel müssen getrennt, das Stromwandlersystem abgezogen und die Stromkabel wieder befestigt werden. Nach erfolgter Überspannungsprüfung müssen dann die Stromkabel erneut getrennt werden, das Stromwandlersystem muss wieder aufgesteckt werden und die Stromkabel wieder montiert werden. Das Entfernen und Wiedermontieren des Stromwandlersystems ist daher sehr zeitaufwändig.

Die WO 2014/090319 A1 beschreibt einen Stromwandler sowie einen Lasttrenner mit einem solchen Stromwandler.

Ausgehend von dem beschriebenen Stand der Technik ist es daher Aufgabe der vorliegenden Erfindung, ein Stromwandlersystem bzw. einen Lasttrenner mit solch einem Stromwandlersystem bereitzustellen, der die beschriebenen Nachteile vermeidet.

Erfindungsgemäß wird diese Aufgabe dadurch gelöst, dass eine Trennvorrichtung zum vorübergehenden Trennen der Verbindung zwischen Stromwandler und Auswerteelektronik vorgesehen ist.

Diese Trennvorrichtung ist ein Schalter, mit deren Hilfe der Stromwandler von der Auswerteelektronik getrennt wird. Kommt es bei Trennung des Stromwandlers von der Auswerteelektronik zu einer Überspannung im Primärkreis, führt dies zwar ebenfalls zu einer Überspannung im Sekundärkreis, da jedoch der Sekundärkreis nicht geschlossen ist bzw. die Auswerteelektronik vom Stromwandler getrennt ist, führt dies nicht zu einer Überspannung der Auswerteelektronik.

Sobald die entsprechende Überspannungsprüfung beendet ist, kann die Trennvorrichtung wieder betätigt werden, um wieder eine Verbindung zwischen Stromwandler und Auswerteelektronik herzustellen.

In einer bevorzugten Ausführungsform weist das Systemgehäuse des Stromwandlersystems eine Stromwandlerkammer, in welcher der Stromwandler untergebracht ist, und eine Auswerteelektronikkammer, in der die Auswerteelektronik untergebracht ist, auf.

Der Stromwandler selbst besteht im Wesentlichen aus dem Sekundärleiter, der den Primärleiter umgibt. Dabei kann der Primärleiter entweder vom Lasttrenner zur Verfügung gestellt werden oder Teil des Stromwandlers sein, wobei im letztgenannten Fall der Primärleiter mit dem Einspeisekontakt oder dem Abgangskontakt verbunden wird.

Dadurch, dass der Stromwandler und damit der Sekundärleiter und die Auswerteelektronik in getrennten Kammern untergebracht sind, ist es in einer bevorzugten Ausführungsform möglich, dass Stromwandlerkammer und Auswerteelektronikkammer relativ zueinander zwischen einer Trennposition, in der die Trennvorrichtung die Verbindung zwischen Stromwandler und Auswerteelektronik trennt, und einer Kontaktposition, in der die Trennvorrichtung die Verbindung zwischen Stromwandler und Auswerteelektronik verbindet, hin- und her bewegbar ist. Weist die Trennvorrichtung beispielsweise eine Steckverbindung auf, so wird diese in der Trennposition getrennt, während sie in der Kontaktposition verbunden ist. Im Grunde genommen kann bei der beschriebenen Ausführungsform die Auswerteelektronikkammer, in der sich die Auswerteelektronik befindet, einfach relativ zum Stromwandlergehäuse verschoben werden, sodass die Verbindung der beiden Kammern getrennt wird. Nun kann die Überspannungsprüfung erfolgen und nach erfolgter Überprüfung kann die Auswerteelektronikkammer wieder zurück in die Kontaktposition geschoben werden. Insbesondere dann, wenn in der Auswerteelektronikkammer die Auswerteelektronik für eine Mehrzahl von Stromwandlern untergebracht ist, kann durch die Verschiebung der Kammer in einfachster Weise der Kontakt zwischen allen Stromwandlern und der Auswerteelektronik sehr leicht vorübergehend getrennt werden.

Um die relative Bewegung zwischen Auswerteelektronikkammer einerseits und Stromwandlerkammer andererseits entsprechend zu führen, ist in einer weiteren Ausführungsform eine Führungseinrichtung vorgesehen, welche eine Relativbewegung zwischen Stromwandlerkammer und Auswerteelektronikkammer in einer Trennrichtung ermöglicht und eine Relativbewegung in zumindest einer hierzu senkrechten Richtung verhindert.

Beispielsweise könnte die Auswerteelektronikkammer mittels einer Gleitführung mit der Stromwandlerkammer verbunden sein. Unter einer Gleitführung versteht man eine Linearführung, bei der die Führungselemente der Führungseinrichtung nicht durch Wälzlager voneinander getrennt sind, sondern aufeinander gleiten. Eine solche Gleitführung kann beispielsweise mittels Lineargleitlagern, Schwalbenschwanzführungen oder auch mittels Schienenführungen verwirklicht werden.

In einer weiteren bevorzugten Ausführungsform weist entweder die Stromwandlerkammer oder die Auswerteelektronikkammer einen Vorsprung oder mehrere Vorsprünge auf und die andere Gehäusekammer weist eine entsprechende schlitzförmige Ausnehmung auf, in die der Vorsprung eingreifen kann. Ist die Ausnehmung größer als der Vorsprung, kann der Vorsprung innerhalb der Ausnehmung zwischen verschiedenen Positionen hin- und herbewegt werden. Beispielsweise kann die Ausnehmung als Schlitz ausgebildet sein, sodass der Vorsprung entlang des Schlitzes verschoben werden kann, um die Auswerteelektronikkammer in die Kontaktposition oder in die Trennposition zu bewegen.

In einer weiteren bevorzugten Ausführungsform sind erste Rastmittel vorgesehen, mittels derer die Auswerteelektronikkammer und die Stromwandlerkammer in der Trennposition und/oder der Kontaktposition gehalten werden können. Diese ersten Rastmittel können derart ausgebildet sein, dass in der Trennposition und/oder der Kontaktposition die Führungseinrichtung eine erhöhte Haft- und oder Gleitreibung zwischen den Führungselementen der Führungseinrichtung zur Verfügung stellt.

Dies kann beispielsweise dadurch erfolgen, dass, um die Auswerteelektronikkammer aus der Trenn- und oder der Kontaktposition zu bewegen, die Rastmittel elastisch verformt werden müssen. So kann beispielsweise die schlitzförmige Ausnehmung einen verjüngten Abschnitt aufweisen, dessen Dicke etwas geringer ist als die Breite des Vorsprungs, sodass der Vorsprung nur dann über den verjüngten Abschnitt bewegt werden kann, wenn die Schlitzbreite durch elastische Verformung vergrößert wird. Dabei kann der verjüngte Abschnitt auch durch ein entsprechend angeordnetes Federelement verwirklicht werden.

Durch diese Maßnahme ist sichergestellt, dass eine ungewollte Relativbewegung zwischen Auswerteelektronikkammer und Stromwandlerkammer unterbunden wird, da die Relativbewegung nur unter Aufbringung einer entsprechenden Kraft möglich ist.

In einer weiteren bevorzugten Ausführungsform sind zweite Rastmittel vorgesehen, mittels derer die Auswerteelektronikkammer und die Stromwandlerkammer in der Kontaktposition und/oder der Trennposition gehalten werden können, die derart ausgebildet sind, dass nur durch Lösen der zweiten Rastmittel Auswerteelektronikkammer und Stromwandlerkammer aus der Kontaktposition und/oder der Trennposition bewegt werden können.

Bei dieser Ausführungsform greift beispielsweise ein Riegel in die oben beschriebene Ausnehmung, um eine Bewegung des Vorsprungs innerhalb der Ausnehmung zu verhindern. Wenn daher die Auswerteelektronikkammer aus der Kontaktposition in Richtung Trennposition bewegt werden soll, muss zunächst der Riegel aus der Ausnehmung entfernt werden.

Beispielsweise kann das Systemgehäuse einen mit der Stromwandlerkammer verbundenen Anschlussraum aufweisen, in welchem Anschlussmittel zum Anschluss eines Stromkabels angeordnet sind. Beispielsweise kann das Stromwandlersystem derart ausgebildet sein, dass es über den bestehenden Abgangskontakt geschoben werden kann, sodass der Abgangskontakt als Primärleiter durch den Stromwandler hindurch in den Anschlussraum reicht, in dem er dann mit entsprechenden Anschlusskabeln kontaktiert werden kann. Dieser Anschlussraum kann eine Anschlussraumabdeckung aufweisen, die zum Befestigen oder Lösen des Stromkabels am Primärleiter geöffnet bzw. geschlossen werden kann. In einer bevorzugten Ausführungsform ist nun vorgesehen, dass die zweiten Rastmittel an der Anschlussraumabdeckung angeordnet sind. Beispielsweise kann der oben beschriebene Riegel an der Anschlussraumabdeckung angeordnet sein, sodass bei auf den Anschlussraum aufgesetzten Anschlussraumabdeckung der Riegel in die Ausnehmung greift und dadurch verhindert, dass die Auswerteelektronikkammer aus der Kontaktposition gebracht wird.

Des Weiteren betrifft die vorliegende Erfindung NH-Sicherungsschaltleisten oder NH-Sicherungslasttrenner mit einem Gehäuse mit einer Bodenfläche und mindestens einem Einspeisekontakt, der vorzugsweise über die Bodenfläche vorsteht, und mindestens einem Abgangskontakt, sowie zumindest einem Sicherungseinsatz, welcher im eingesetzten Zustand den Einspeisekontakt mit dem Abgangskontakt verbindet, wobei erfindungsgemäß ein Stromwandlersystem wie oben beschrieben vorgesehen ist. Dabei ist in einer besonders bevorzugten Ausführungsform vorgesehen, dass der Stromwandler den Abgangskontakt umgebend angeordnet ist.

Weitere Vorteile, Merkmale und Anwendungsmöglichkeiten der vorliegenden Erfindung werden deutlich anhand der folgenden Beschreibung einer bevorzugten Ausführungsform sowie der zugehörigen Figuren. Es zeigen:
- Figur 1: eine Seitenansicht eines erfindungsgemäßen Stromwandlersystems,
- Figur 2: eine Seitenansicht des Stromwandlersystems von Figur 1 mit abgenommener Abdeckung in der Kontaktposition,
- Figur 3: eine Seitenansicht des Stromwandlersystems der Figuren 1 und 2 mit abgenommener Abdeckung in der Trennposition,
- Figur 4: eine perspektivische Ansicht des Stromwandlersystems der Figuren 1 bis 3,
- Figur 5: eine Draufsicht auf das Stromwandlersystem der Figuren 1 bis 4 und
- Figur 6: eine perspektivische Ansicht eines Lasttrenners mit einem entsprechenden Stromwandlersystem.

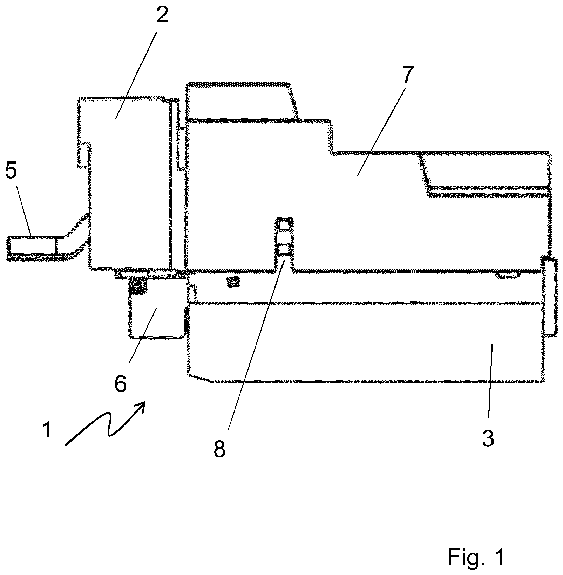

In Figur 1 ist eine Seitenansicht eines erfindungsgemäßen Stromwandlersystems 1 gezeigt. Das Stromwandlersystem 1 weist ein Systemgehäuse 2, 3, 4 auf, das aus der Stromwandlerkammer 2, der Auswerteelektronikkammer 3 sowie einem Anschlussblock 4 besteht, welcher von der Anschlussblockabdeckung 7 verdeckt ist. Innerhalb der Stromwandlerkammer 2 ist der Stromwandler, der im Wesentlichen aus dem Sekundärleiter besteht, angeordnet. In der Figur dargestellt ist ein Ausgangskontakt 5, der entweder Teil des Stromwandlersystems 1 oder Teil eines Lasttrenners (nicht dargestellt) sein kann. Im letzteren Fall ist der Primärleiter 5 der Abgangskontakt des Lasttrenners.

In der Auswerteelektronikkammer 3 ist die entsprechende Auswerteelektronik, die im Wesentlichen aus einer Platine besteht, auf der elektronische Bauteile angeordnet sind, angeordnet. Die Auswerteelektronik dient dazu, die von dem Stromwandler bereitgestellte Messspannung auszuwerten. Diese Messspannung, die vom Stromwandler bereitgestellt wird, wird über den Stecker 6 der Auswerteelektronik 3 zur Verfügung gestellt. Oberhalb der Auswerteelektronikkammer 3 ist der Anschlussblock 4 dargestellt. Dieser dient im Wesentlichen dazu, einen Raum zu schaffen, in dem entsprechende Abgangskabel mit dem durch den Stromwandler verlaufenden Primärleiter 5 zu verbinden.

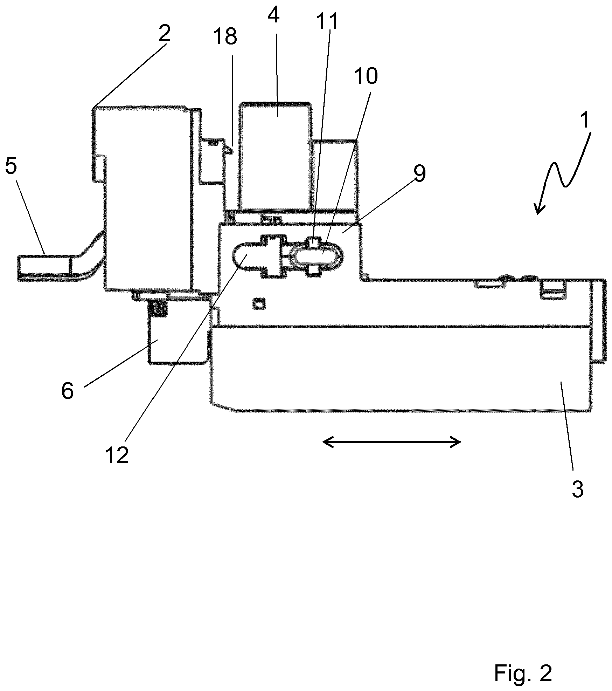

Der Anschlussblock 4 weist eine Anschlussraumabdeckung 7 auf. In Figur 2 ist eine entsprechende Ansicht des Stromwandlersystems 1 gezeigt, bei der die Anschlussraumabdeckung 7 entfernt worden ist.

Man erkennt, dass die Auswerteelektronikkammer 3 zwei abstehende Laschen 9 aufweist, in denen längliche, die Laschen vollständig durchgreifende Ausnehmungen 12 angeordnet sind. In der Stromwandlerkammer bzw. an dem mit dieser verbundenen Anschlussblock 4 sind korrespondierende Vorsprünge 10 angeordnet, die innerhalb der Ausnehmungen 12 positioniert sind. Die Ausnehmungen 12 sind länglich ausgeführt, sodass die Auswerteelektronikkammer 3 in Pfeilrichtung relativ zur Stromwandlerkammer 2 hin- und herbewegt werden kann.

Um ein versehentliches Lösen der Laschen 9 von dem Anschlussblock 4 zu verhindern, sind Führungen 11 vorgesehen, in denen die Laschen 9 geführt werden. Diese Führungen stehen über die Vorsprünge 10 vor. Die Anschlussraumabdeckung 7 weist entsprechende Schlitze auf, in denen die vorstehenden Führungen 11 angeordnet sind, wenn die Auswerteelektronikkammer in der Kontaktposition ist und die Anschlussraumabdeckung 7 aufgesetzt ist. Beim Aufsetzen der Anschlussraumabdeckung 7 verrastet diese über die Klinke 18 mit dem Anschlussblock 4, so dass die Anschlussraumabdeckung 7 nicht relativ zu der Auswerteelektronikkammer 3 bewegt werden kann. Da gleichzeitig die Führungen 11 in die Schlitze eingreifen, kann die Auswerteelektronikkammer 3 nicht aus der Kontaktposition bewegt werden, ohne dass vorher die Anschlussraumabdeckung 7 entfernt worden ist. In dieser Ausführungsform werden durch die Anschlussraumabdeckung 7 die zweiten Rastmittel verwirklicht.

In der in Figur 2 dargestellten Position ist das Stromwandlergehäuse 2 über den Stecker 6 mit der Auswerteelektronikkammer verbunden, sodass die Auswerteelektronik mit der Messspannung versorgt wird, die der Sekundärleiter des Stromwandlers zur Verfügung stellt.

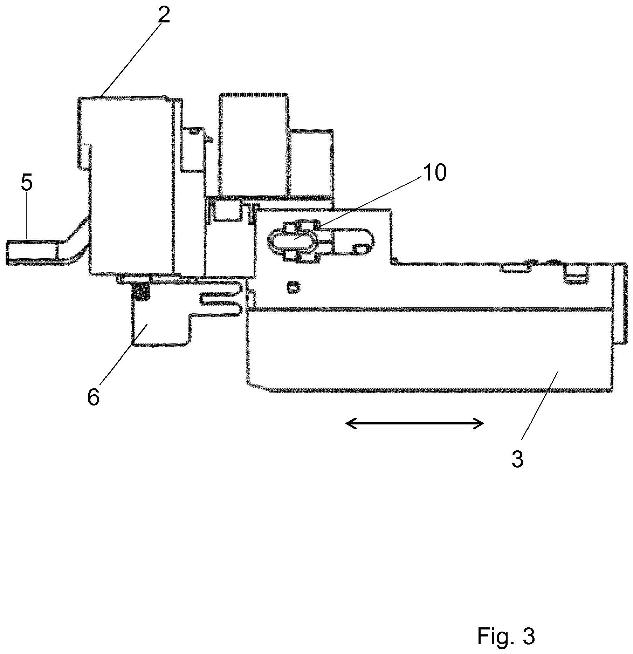

In Figur 3 ist eine Seitenansicht des erfindungsgemäßen Stromwandlersystems 1 in der Trennposition gezeigt. Die Figur 3 unterscheidet sich von Figur 2 dadurch, dass nun die Auswerteelektronikkammer 3 in die Trennposition, d.h. in der Figur 3 nach rechts, verschoben ist. Man erkennt, dass der Vorsprung 10, der fest mit dem Stromwandler verbunden ist, nun am linken Ende der Ausnehmung 12 angeordnet ist.

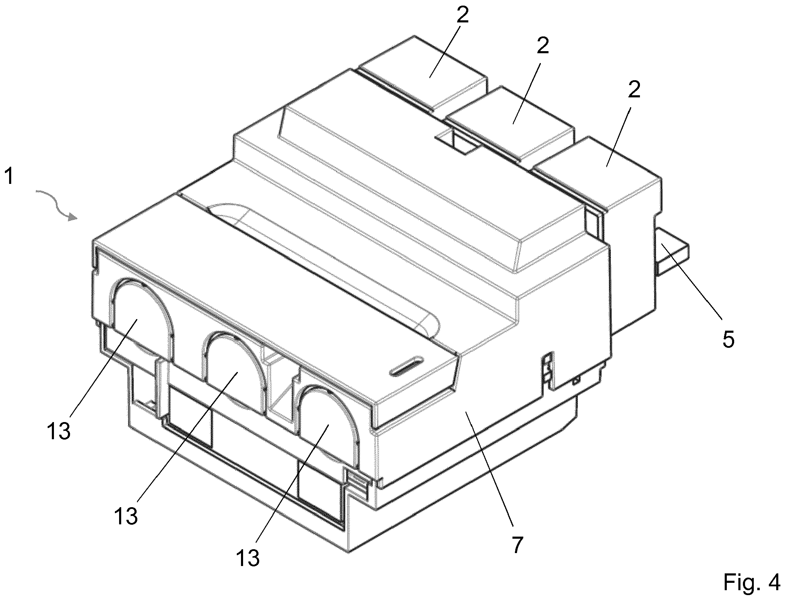

In Figur 4 ist eine perspektivische Ansicht des Stromwandlersystems 1 dargestellt. Man erkennt hier, dass das System 1 drei Stromwandler 2 aufweist. Die Anschlussraumabdeckung 7 weist an ihrer den Stromwandlern 2 abgewandten Seite drei halbrunde Ausnehmungen 13 auf, durch die die entsprechenden Stromkabel geführt werden können.

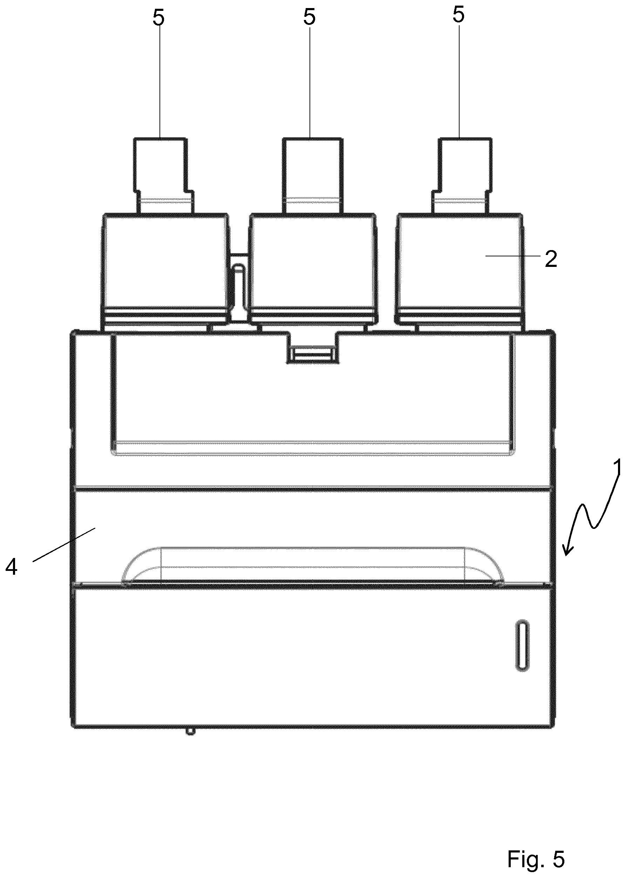

In Figur 5 ist eine Draufsicht auf das Stromwandlersystem 1 dargestellt.

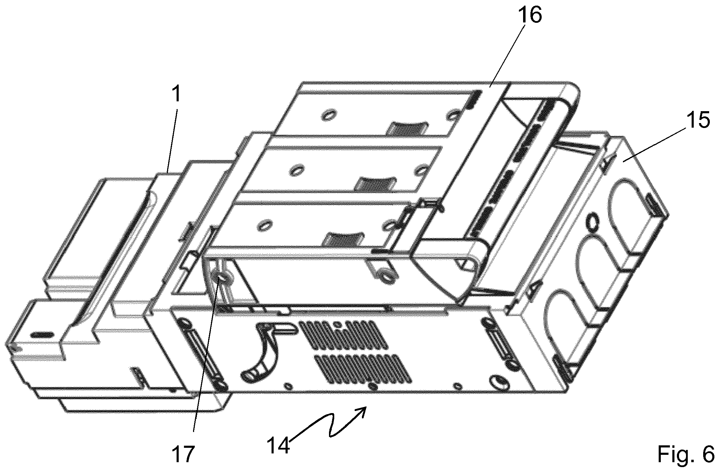

Schließlich ist in Figur 6 eine perspektivische Ansicht eines Lasttrenners 14 gezeigt, an dem ein entsprechendes Stromwandlersystem 1 angeordnet ist. Der Lasttrenner 14 weist ein Gehäuse 15 auf, an dessen Unterseite der Eingangsanschluss angeordnet ist, der mit entsprechenden Stromsammelschienen verbunden werden kann. Innerhalb des Gehäuses 15 sind entsprechende Sicherungsunterteile angeordnet, wobei entsprechende Sicherungseinsätze am Schaltdeckel 16 angeordnet sind. Der Schaltdeckel 16 kann über die Gelenkverbindung 17 relativ zum Gehäuse 15 verschwenkt werden, wobei beim Öffnen des Deckels 16 die Sicherungseinsätze aus den Sicherungsunterteilen gezogen werden, sodass keine Verbindung mehr zwischen den Eingangsanschlüssen und den Abgangskontakten besteht. Auf den Abgangskontakten ist das Stromwandlersystem 1 aufgeschoben.

### Bezugszeichenliste

- 1: Stromwandlersystem
- 2: Stromwandler
- 3: Auswerteelektronikkammer
- 4: Anschlussblock
- 5: Primärleiter
- 6: Stecker
- 7: Anschlussraumabdeckung
- 8: Ausnehmung der Anschlussraumabdeckung
- 9: Laschen
- 10: Vorsprung
- 11: Führung
- 12, 13: Ausnehmung
- 14: Lasttrenner
- 15: Gehäuse
- 16: Deckel
- 17: Gelenkverbindung
- 18: Klinke

## Patentansprüche

1. Stromwandlersystem für eine NH-Sicherungsschaltleiste oder einen NH-Sicherungslasttrenner mit einem Stromwandler (2), der einen durch den Stromwandler (2) fließenden Strom erfasst und in eine Messspannung umwandelt, und einer Auswerteelektronik, welche mit dem Stromwandler (2) verbunden ist und die Messspannung verarbeitet, wobei sowohl Stromwandler (2) als auch Auswerteelektronik in einem Systemgehäuse (15) angeordnet ist, **dadurch gekennzeichnet, dass** ein Schalter zum vorübergehenden Trennen der Verbindung zwischen Stromwandler (2) und Auswerteelektronik vorgesehen ist.

2. Stromwandlersystem nach Anspruch 1 , **dadurch gekennzeichnet, dass** das Systemgehäuse (15) eine Stromwandlerkammer, in welcher der Stromwandler untergebracht ist, und eine Auswerteelektronikkammer (3), in der die Auswerteelektronik untergebracht ist, aufweist.

3. Stromwandlersystem nach Anspruch 2, **dadurch gekennzeichnet, dass** Stromwandlerkammer und Auswerteelektronikkammer (3) relativ zueinander zwischen einer Trennposition, in der der Schalter die Verbindung zwischen Stromwandler (2) und Auswerteelektronik trennt, und einer Kontaktposition, in der der Schalter die Verbindung zwischen Stromwandler (2) und Auswerteelektronik verbindet, hin und her bewegbar ist.

4. Stromwandlersystem nach Anspruch 3, **dadurch gekennzeichnet, dass** eine Führungseinrichtung vorgesehen ist, welche eine Relativbewegung zwischen Stromwandlerkammer und Auswerteelektronikkammer (3) in einer Trennrichtung ermöglicht und eine Relativbewegung in einer hierzu senkrechten Richtung verhindert, wobei vorzugsweise die Führungseinrichtung eine Relativbewegung in allen zur Trennrichtung senkrechten Richtungen verhindert.

5. Stromwandlersystem nach Anspruch 4, **dadurch gekennzeichnet, dass** die Führungseinrichtung einen Vorsprung (10) und eine zu dem Vorsprung (10) korrespondierende Ausnehmung (12, 13) aufweist, wobei der Vorsprung (10) entweder an der Stromwandlerkammer oder an der Auswerteelektronikkammer (3) und die Ausnehmung (12, 13) an der anderen Kammer angeordnet ist.

6. Stromwandlersystem nach Anspruch 3, 4 oder 5, **dadurch gekennzeichnet, dass** erste Rastmittel vorgesehen sind, mittels derer die Auswerteelektronikkammer (3) und die Stromwandlerkammer in der Trennposition und/oder der Kontaktposition gehalten werden können, so dass nur durch elastische Verformung der Rastmittel Auswerteelektronikkammer (3) und Stromwandlerkammer aus dieser Position bewegt werden können.

7. Stromwandlersystem nach einem der Ansprüche 3 bis 6, **dadurch gekennzeichnet, dass** zweite Rastmittel vorgesehen sind, mittels derer die Auswerteelektronikkammer (3) und die Stromwandlerkammer in der Kontaktposition gehalten werden können, so dass nur durch Lösen der zweiten Rastmittel Auswerteelektronikkammer und Stromwandlerkammer aus der Kontaktposition bewegt werden können.

8. Stromwandlersystem nach Anspruch 7, **dadurch gekennzeichnet, dass** das Systemgehäuse (15) einen mit der Stromwandlerkammer verbundenen Anschlussraum aufweist, in welchem Anschlussmittel zum Anschluss eines Stromkabels angeordnet sind, wobei der Anschlussraum eine Anschlussraumabdeckung (7) aufweist, an welcher die zweiten Rastmittel angeordnet sind.

9. NH-Sicherungsschaltleiste oder NH-Sicherungslasttrenner mit einem Gehäuse mit einer Bodenfläche und mindestens einem Einspeisekontakt, der vorzugsweise über die Bodenfläche vorsteht, und mindestens einem Abgangskontakt, sowie zumindest einem Sicherungseinsatz, welcher im eingesetzten Zustand den Einspeisekontakt mit dem Abgangskontakt verbindet, **dadurch gekennzeichnet, dass** ein Stromwandlersystem (1) nach einem der Ansprüche 1 bis 8 vorgesehen ist.

10. NH-Sicherungsschaltleiste oder NH-Sicherungslasttrenner nach Anspruch 9, **dadurch gekennzeichnet, dass** der Stromwandler den Abgangskontakt umgebend angeordnet ist.

## Claims

1. Current transformer system for an NH fuse block or an NH fused load disconnector comprising a converter (2), which detects a current flowing through the current converter (2) and converts the said current into a measurement voltage, and an evaluation electronics system, which is connected to the current converter (2) and processes the measurement voltage, wherein both the current converter (2) and the evaluation electronics system are arranged in a system housing (15), **characterized in that** a switch is provided for temporarily disconnecting the connection between the current converter (2) and the evaluation electronics system.

2. Current converter system according to Claim 1, **characterized in that** the system housing (15) has a current converter chamber, in which the current converter is accommodated, and an evaluation electronics chamber (3), in which the evaluation electronics system is accommodated.

3. Current converter system according to Claim 2, **characterized in that** the current converter chamber and the evaluation electronics chamber (3) can be moved back and forth relative to one another between a disconnection position, in which the switch disconnects the connection between the current converter (2) and the evaluation electronics system, and a contact position, in which the switch connects the connection between the current converter (2) and the evaluation electronics system.

4. Current converter system according to Claim 3, **characterized in that** a guide device is provided, which renders possible a relative movement between the current converter chamber and the evaluation electronics chamber (3) in a disconnection direction and prevents a relative movement in a direction perpendicular in relation to the said disconnection direction, wherein the guide device preferably prevents a relative movement in all directions perpendicular in relation to the disconnection direction.

5. Current converter system according to Claim 4, **characterized in that** the guide device has a projection (10) and a recess (12, 13) which corresponds to the projection (10), wherein the projection (10) is arranged either on the current converter chamber or on the evaluation electronics chamber (3) and the recess (12, 13) is arranged on the other chamber.

6. Current converter system according to Claim 3, 4 or 5, **characterized in that** first latching means are provided, by means of which the evaluation electronics chamber (3) and the current converter chamber can be held in the disconnection position and/or the contact position, so that the evaluation electronics chamber (3) and the current converter chamber can be moved out of the said position only by elastic deformation of the latching means.

7. Current converter system according to one of Claims 3 to 6, **characterized in that** second latching means are provided, by means of which the evaluation electronics chamber (3) and the current converter chamber can be held in the contact position, so that the evaluation electronics chamber and the current converter chamber can be moved out of the contact position only by releasing the second latching means.

8. Current converter system according to Claim 7, **characterized in that** the system housing (15) has a connection area which is connected to the current converter chamber and in which connection means for connection of a power cable are arranged, wherein the connection area has a connection area cover (7) on which the second latching means are arranged.

9. NH fuse block or NH fused load disconnector comprising a housing with a bottom surface and at least one feed contact, which preferably projects beyond the bottom surface, and at least one outgoer contact and also at least one fuse insert which, in the inserted state, connects the feed contact to the outgoer contact, **characterized in that** a current converter system (1) according to one of Claims 1 to 8 is provided.

10. NH fuse block or NH fused load disconnector according to Claim 9, **characterized in that** the current converter is arranged so as to surround the outgoer contact.

## Revendications

1. Système convertisseur de courant pour une réglette coupe-circuit NH ou un sectionneur-fusible NH, comprenant un convertisseur de courant (2) qui détecte un courant circulant à travers le convertisseur de courant (2) et le transforme en une tension de mesure, et une électronique d'évaluation qui est reliée au convertisseur de courant (2) et traite la tension de mesure, le convertisseur de courant (2) et l'électronique d'évaluation étant disposés dans un boîtier de système (15), **caractérisé en ce qu'**un commutateur est prévu pour séparer temporairement la liaison entre le convertisseur de courant (2) et l'électronique d'évaluation.

2. Système convertisseur de courant selon la revendication 1, **caractérisé en ce que** le boîtier de système (15) présente une chambre de convertisseur de courant dans laquelle le convertisseur de courant est logé et une chambre d'électronique d'évaluation (3) dans laquelle l'électronique d'évaluation est logée.

3. Système convertisseur de courant selon la revendication 2, **caractérisé en ce que** la chambre de convertisseur de courant et la chambre d'électronique d'évaluation (3) peuvent être déplacées l'une par rapport à l'autre entre une position de séparation, dans laquelle le commutateur sépare la liaison entre le convertisseur de courant (2) et l'électronique d'évaluation, et une position de contact, dans laquelle le commutateur établit la liaison entre le convertisseur de courant (2) et l'électronique d'évaluation.

4. Système convertisseur de courant selon la revendication 3, **caractérisé en ce qu'**il est prévu un dispositif de guidage qui permet un mouvement relatif entre la chambre de convertisseur de courant et la chambre d'électronique d'évaluation (3) dans une direction de séparation et empêche un mouvement relatif dans une direction perpendiculaire à celle-ci, le dispositif de guidage empêchant de préférence un mouvement relatif dans toutes les directions perpendiculaires à la direction de séparation.

5. Système convertisseur de courant selon la revendication 4, **caractérisé en ce que** le dispositif de guidage présente une saillie (10) et un évidement (12, 13) correspondant à la saillie (10), la saillie (10) étant disposée soit sur la chambre de convertisseur de courant, soit sur la chambre d'électronique d'évaluation (3) et l'évidement (12, 13) étant disposé sur l'autre chambre.

6. Système convertisseur de courant selon la revendication 3, 4 ou 5, **caractérisé en ce qu'**il est prévu des premiers moyens d'encliquetage au moyen desquels la chambre d'électronique d'évaluation (3) et la chambre de convertisseur de courant peuvent être maintenues dans la position de séparation et/ou la position de contact, de sorte que seule une déformation élastique des moyens d'encliquetage permet de déplacer la chambre d'électronique d'évaluation (3) et la chambre de convertisseur de courant à partir de cette position.

7. Système convertisseur de courant selon l'une des revendications 3 à 6, **caractérisé en ce qu'**il est prévu des deuxièmes moyens d'encliquetage au moyen desquels la chambre d'électronique d'évaluation (3) et la chambre de convertisseur de courant peuvent être maintenues dans la position de contact, de sorte que seule une libération des deuxièmes moyens d'encliquetage permet de déplacer la chambre d'électronique d'évaluation et la chambre de convertisseur de courant à partir de la position de contact.

8. Système convertisseur de courant selon la revendication 7, **caractérisé en ce que** le boîtier de système (15) présente un espace de raccordement relié à la chambre de convertisseur de courant, dans lequel sont disposés des moyens de raccordement pour raccorder un câble électrique, l'espace de raccordement présentant un couvercle d'espace de raccordement (7) sur lequel sont disposés les deuxièmes moyens de verrouillage.

9. Réglette coupe-circuit NH ou sectionneur-fusible NH comportant un boîtier avec une surface de base et au moins un contact d'alimentation qui, de préférence, fait saillie de la surface de base, et au moins un contact de sortie ainsi qu'au moins une cartouche fusible qui, à l'état inséré, relie le contact d'alimentation au contact de sortie, caractérisé(e) en ce qu'un système convertisseur de courant (1) selon l'une des revendications 1 à 8 est prévu.

10. Réglette coupe-circuit NH ou sectionneur-fusible NH selon la revendication 9, caractérisé(e) en ce que le convertisseur de courant est disposé de manière à entourer le contact de sortie.
